# EUROPEAN PATENT APPLICATION

(11) **EP 4 286 042 A1**
(43) Date of publication of application: **06.12.2023**
(21) Application number: 22176397.2
(22) Date of filing: 31.05.2022
(51) Int. Cl.: B01J 19/00, G11C 13/00

(54) **A MOLECULAR SYNTHESIS ARRAY**

(71) Applicant: Imec VZW, 3001 Leuven (BE)
(72) Inventor: LOCKHART DE LA ROSA, Cesar Javier, 3150 Haacht (BE)
(74) Representative: AWA Sweden AB

(57) **Abstract**

According to an aspect of the present inventive concept there is provided a molecular synthesis array comprising: a substrate; an insulating layer (202) arranged on the substrate; a plurality of column lines (102) extending in parallel along a column direction of the molecular synthesis array (100), and a plurality of row lines (104) extending in parallel along a row direction of the molecular synthesis array (100), wherein the column lines (102) are vertically separated from the row lines (104) and extend transverse to the row lines (104); a plurality of synthesis cells (105), wherein each cell (200) is coupled to a respective pair of a column line and a row line and comprises: a lower electrode (226) and an upper electrode (206) vertically separated from each other and embedded in the insulating layer (202), a synthesis well (223) extending from an upper surface (225) of the insulating layer (202) to the lower electrode (226), through the insulating layer (202) and through the upper electrode (206), wherein the well (223) exposes a surface portion (214) of the upper electrode (206) and a surface portion (220) of the lower electrode (226), and a select transistor (106) having a first terminal (114a), a second terminal (114b) and a gate terminal (114c), the first and second terminals (114a, 114b) forming respective source/drain terminals of the select transistor (106), wherein the gate terminal (114c) is coupled to the row line, the first terminal (114a) is coupled to the column line, the second terminal (114b) is coupled to the lower electrode (226), and the upper electrode (206) is coupled to a reference voltage, or wherein the gate terminal (114c) is coupled to the row line, the first terminal (114a) is coupled to the column line, the second terminal (114b) is coupled to the upper electrode (206), and the lower electrode (226) is coupled to a reference voltage.

## Description

### Technical field

The present inventive concept relates to a molecular synthesis array. The present inventive concept further relates to a molecular synthesis device, a data storage system comprising a molecular synthesis device and a method for enabling synthesis in a molecular synthesis device.

### Background

DNA (deoxyribonucleic acid) chips provide a collection of nucleic acid strands immobilized at defined locations on a solid surface. DNA chips allow for high-throughput electrochemical synthesis of DNA and have become a core technology in the field of bio-analytics and bio-medical diagnostics. Lately, DNA microarrays have become a powerful tool beyond the traditional gene expression experiments in many other research areas, for instance for gene assembly, DNA origami or as a platform for data storage.

DNA chips may comprise arrays of electrodes providing electrochemically controlled *in situ* synthesis of different oligonucleotides at defined positions in the array. As advances in microfabrication technology enables scaling of the electrodes, it is envisaged that such arrays has the potential to allow for high density and high throughput DNA synthesis. Although reference in the above is made to arrays for DNA synthesis, this technology is not limited to synthesis of DNA, but may more generally be used for synthesis of organic molecules, such as polymers, DNA or ribonucleic acid (RNA).

Up to know, microarrays for molecular synthesis typically rely on a structure where every electrode (and thus every synthesis location) is addressed one-by-one. While this may facilitate selective addressing of the synthesis locations, it makes scaling more challenging as the increased number or electrodes complicates the routing of the electrodes, and also as the area needed for routing will limit the density of electrodes. This may in effect limit the density of synthesis locations which may be achieved in the array.

### Summary

In view of the above, it would be desirable to provide a molecular synthesis array enabling a relatively large number of synthesis locations in a relatively small area (i.e. a high density of synthesis locations), e.g. in order to facilitate storage of large amount of data in the array. At the same time, it would be desirable to enable selective addressing of the individual synthesis locations, to provide individual control over the synthesis reaction at each synthesis location (i.e. to avoid activating neighboring synthesis locations). It is an object of the present inventive concept to address these needs. Further and alternative objectives may be understood from the following.

According to a first aspect of the present inventive concept there is provided a molecular synthesis array. The molecular synthesis array comprises: a substrate; an insulating layer arranged on the substrate; a plurality of column lines extending in parallel along a column direction of the molecular synthesis array, and a plurality of row lines extending in parallel along a row direction of the molecular synthesis array, wherein the column lines are vertically separated from the row lines and extend transverse to the row lines; a plurality of synthesis cells, wherein each cell is coupled to a respective pair of a column line and a row line and comprises: a lower electrode and an upper electrode vertically separated from each other and embedded in the insulating layer, a synthesis well extending from an upper surface of the insulating layer to the lower electrode, through the insulating layer and through the upper electrode, wherein the well exposes a surface portion of the upper electrode and a surface portion of the lower electrode, and a select transistor having a first terminal, a second terminal and a gate terminal, the first and second terminals forming respective source/drain terminals of the select transistor, wherein the gate terminal is coupled to the row line, the first terminal is coupled to the column line, the second terminal is coupled to the lower electrode, and the upper electrode is coupled to a reference voltage, or wherein the gate terminal is coupled to the row line, the first terminal is coupled to the column line, the second terminal is coupled to the upper electrode, and the lower electrode is coupled to reference voltage.

The inventive molecular synthesis array of the first aspect may enable a number of advantages:
(i) increasing the feasibility of area efficient synthesis arrays with a large numbers of synthesis locations,
(ii) the well structure of the synthesis locations reduces the risk of crosstalk between neighboring synthesis wells,
(iii) less complexity during fabrication as the need for a separate dedicated capacitor (as the potential in the synthesis well itself can be utilized instead) is mitigated, and
(iv) the number of electrode connections needed can scale proportionally to the square root of the number of electrodes instead of scaling proportional to the number of electrodes as in an array wherein each electrode (and thus every synthesis location) is addressed one-by-one.

These advantages may be better and more fully understood from the following.

According to the molecular synthesis array, an array of synthesis cells may be defined, wherein each synthesis cell (or more specifically its synthesis well) may define a respective synthesis location (i.e. a synthesis spot), i.e. a location in the array where a molecular synthesis reaction may be enabled by electrical activation of the column and row lines coupled to the electrodes of the synthesis cells. More specifically, the molecular synthesis array and the synthesis wells thereof may, in use, be supplied with a molecular synthesis medium, for instance a liquid solution including reagents for a synthesis reaction.

The upper and lower electrodes (or more specifically the surface portions of the upper and lower electrodes exposed at each synthesis well) may be configured to control a reaction condition at the respective synthesis cells. The surface portions at each synthesis well may be configured to, in response to being activated, enable or inhibit a chemical reaction in the molecular synthesis medium. The molecular synthesis medium of each synthesis well (and any reagents supplied to the synthesis wells) may be such that a chemical reaction will be inhibited (i.e. will not occur) unless the associated electrode is activated. Alternatively, the molecular synthesis medium of each synthesis well may be such that a chemical reaction will be enabled (i.e. will occur) unless the associated electrode is activated. In other words, an electrode may, depending on the particular type of synthesis, either be configured to enable the reaction or inhibit the reaction when being activated.

According to the molecular synthesis array, the gate terminal may be coupled to the row line, the first terminal may be coupled to the column line, the second terminal may be coupled to the lower electrode, and the upper electrode may be coupled to a reference voltage. This configuration of a synthesis cells may in the following be referred to as the "first cell configuration". Alternatively, the gate terminal may be coupled to the row line, the first terminal may be coupled to the column line, the second terminal may be coupled to the upper electrode, and the lower electrode may be coupled to reference voltage. This configuration of a synthesis cells may in the following be referred to as the "second cell configuration".

In both the first and second cell configurations, the reference voltage may be a fixed reference voltage, for example a ground voltage, or a reference voltage switchable between a first and second reference voltage level, for example a ground voltage and a positive reference voltage.

By "activating" or "biasing" an electrode of a synthesis cell is hereby meant supplying the electrode with a current or voltage. The voltage may be supplied via the column line coupled to the synthesis cell or the reference voltage. The voltage may be of such a magnitude that the chemical reaction is enabled or inhibited, as the case may be.

The transverse (i.e. crossing) arrangement of column and row lines enables what may be referred to as a "cross bar structure", wherein a specific electrode and synthesis location can be addressed by biasing a column line (e.g. corresponding to a working electrode - WE) and a row line (e.g. corresponding to a counter electrode - CE) instead of addressing each of the electrodes individually. This can conceptually be compared to addressing of bit cells in traditional crossbar solid-state memory cells (equivalent to the electrode surfaces at the synthesis wells) by biasing word lines and bit lines.

By the biasing of row and column lines, the cross bar structure can effectively reduce the amount of connections needed to address electrodes from one connection per electrode to a value that is proportional to the square root of the number of electrodes. Thus, an improved scalability and area efficiency may be achieved.

Furthermore, the surface portions of the upper and lower electrodes exposed in each synthesis well may be capacitively coupled to each other to thereby provide the synthesis well with a self-capacitance, thus allowing a charge to be stored at the synthesis well for an amount of time. Thus, a bias across the synthesis well for enabling a synthesis reaction may be maintained after an external biasing voltage via the column and row lines has been removed, without the need for e.g. an external capacitor. As will be described in detail below, this enables a time-multiplexed biasing scheme for parallel synthesis in a plurality of synthesis wells.

The well structure of the synthesis cells further provides advantages associated with the synthesis reaction itself. The synthesis wells may define a comparably small partial volume relative the larger common volume of the molecular synthesis array located above the synthesis wells. Thus, the electrically induced reaction conditions for the synthesis reaction may be at least partially confined to each respective synthesis well. This may reduce the risk of cross-talk between neighboring synthesis wells. As a non-limiting and illustrative example, in a synthesis reaction wherein a reaction rate is dependent on the concentration of protons produced from a redox reaction in the reagent solution, a desired concentration of protons may be achieved locally in the partial volume of a selected synthesis well by biasing of the lower and upper electrodes at the synthesis well. Even if some protons (e.g. driven by the increased concentration of protons) may diffuse out of the selected synthesis well, the proton concentration may drop abruptly in the larger volume outside the synthesis well. Proton out-diffusion from a (selected) synthesis cell may hence have a negligible impact on the reaction conditions in neighboring (non-selected) synthesis wells.

The provision of a select transistor in each synthesis cell allows the synthesis cells to be selectively enabled, with a minimum risk of cross-talk, even if the synthesis cells are provided in relatively close proximity to each other.

Relative spatial terms such as "upper", "lower", "vertical" and "arranged on" may be used herein to refer to locations or directions within a frame of reference of the molecular synthesis array. In particular, these terms may be understood in relation to a bottom-up direction of the molecular synthesis array, i.e. a normal direction to (a main plane of extension) of the substrate. Correspondingly, the term "horizontal" may be understood as locations or orientations transverse to the bottom-up direction, i.e. in relation to / along (the main plane of extension of) the substrate.

The row direction and column direction should be understood as mutually transverse (horizontal) directions, each parallel to the substrate.

By the wording the column lines "extend across" the row lines, or vice versa, is hereby meant that the column lines extend over and past the row lines, or vice versa. In other words, the column lines are arranged to define an overlap with the row lines, as seen along a vertical direction (e.g. towards the substrate). Correspondingly, the wording "at a crossing", as in "at a crossing between a row line and an column line", is to be understood as the location where the row and column lines define an overlap, as seen along a vertical direction (e.g. towards the substrate).

By the wording the column lines are "vertically separated" from the row lines, it is hereby meant that the column and row lines are separated both physically and galvanically along the vertical direction. The same holds for the lower electrode and the upper electrode of each synthesis cell.

By the wording "embedded", as in the upper electrodes and lower electrodes being "embedded in the insulating layer", it is herein meant that the column and row lines are surrounded by the insulating layer.

The well of each synthesis cell may comprise an upper portion extending from the upper surface of the insulating layer to the upper electrode and exposing an upper surface portion of the upper electrode, and a lower portion extending from the upper electrode to the lower electrode.

Providing the synthesis wells with a lower and upper well portion, allows a depth of the synthesis well to be increased without increasing a vertical separation between the upper and lower electrode.. A deeper synthesis well may contribute to confining the reaction conditions to the selected synthesis well. For example, protons may in use of the synthesis array be generated in the lower portion of a selected synthesis well. Having the upper well portion exposing an upper surface portion of the upper electrode allows an area of the upper surface portion of the upper electrode to be increased relative to an area of the surface portion of the lower electrode. This may allow balancing a reaction occurring at the surface portion of the lower electrode and at the upper surface portion of the upper electrode. Assuming for instance the surface portions of the lower and upper electrodes are configured as a working electrode and a counter electrode, respectively, protons generated by an oxidizing reaction at the working electrode may be consumed in a redox redaction at the counter electrode. This may in turn reduce out-diffusion of protons which may cause crosstalk between synthesis cells.

A cross-sectional area of the upper portion of each well may be larger than a cross-sectional area of the lower portion of the well. More specifically, the upper surface portion of the upper electrode may be larger than the surface portion of the lower electrode.

In line with the above discussion, the upper surface portion of the upper electrode may thereby enable that protons produced at the surface portion of the lower electrode are consumed by the upper surface portion of the upper electrode to a large extent. Thus, reducing the risk of protons escaping from the synthesis well.

An area of the exposed upper surface portion of the upper electrode may be at least two times larger than an area of the exposed surface portion of the lower electrode. The area of the exposed upper surface portion of the upper electrode may be about three times larger than the area of the exposed surface portion of the lower electrode.

This may ensure a sufficiently large surface area of the upper surface portion of the upper electrode relative the surface area of the surface portion of the lower electrode.

The select transistor of each synthesis cell may be a first select transistor of a first conductivity type and each synthesis cell may further comprise a second select transistor of an opposite second conductivity type and having a first terminal, a second terminal and a gate terminal, the first and second terminals may form respective source/drain terminals of the second select transistor, wherein the gate terminals of each of the select transistors may be coupled to the row line, the first terminals may be coupled to the column line and the second terminal may be coupled to the lower electrode (in the first cell configuration), or wherein the gate terminals of each of the select transistors may be coupled to the row line, the first terminals may be coupled to the column line and the second terminals may be coupled to the upper electrode (in the second cell configuration).

In other words, the select transistor may be a complementary metal-oxide-semiconductor, CMOS. Having a pair of select transistors of opposite conductivity type allows the synthesis wells to be biased with both negative and positive polarity voltages by applying via the column line a voltage which is either higher or a lower than the (fixed) reference voltage. For example, if the upper electrode (in case of the first cell configuration) or lower electrode (in case of the second cell configuration) is connected to a ground level reference voltage, a positive polarity voltage (as seen from the lower electrode to the upper electrode) may be provided by applying a positive voltage to the column line, while a negative polarity voltage may be provided by applying a negative voltage to the column line.

Each lower electrode may be configured as a working electrode and each upper electrode may be configured as a counter electrode.

Accordingly, in response to a positive (negative) voltage, the working electrode may act as a proton producing (consuming) electrode and the counter electrode may act as a proton consuming (producing) electrode.

A vertical separation between the lower electrode and the upper electrode of each synthesis cell may be smaller than a spacing of the synthesis wells. In other words, a vertical distance between the upper electrode and the lower electrode in a synthesis well may be smaller than a horizontal distance between two neighboring synthesis wells.

A vertical separation between the plurality of lower electrode lines and the plurality of upper electrode lines may be 40 to 300 nm, and a spacing of the synthesis wells may be at least 40 nm.

According to a second aspect of the present inventive concept, there is provided a molecular synthesis device. The molecular synthesis device comprises a molecular synthesis array according to the first aspect, and further comprising an array controller configured to enable synthesis in a selected synthesis cell among the plurality of synthesis cells of the molecular synthesis array by: applying a select voltage to the row line coupled to the selected synthesis cell and a synthesis voltage to the column line coupled to the selected synthesis cell. The array controller may thus supply a synthesis voltage to a selected synthesis cell along an activated row line.

The array controller may be further configured to enable synthesis in a set of selected synthesis cells in parallel by applying a respective train of select voltage pulses to the row lines coupled to each respective synthesis cell of the set of selected synthesis cells, and a respective train of synthesis voltage pulses to the column lines coupled to each respective synthesis cell of the set of selected synthesis cells, wherein the trains of select voltage pulses and the trains of synthesis voltage pulses are applied to the molecular synthesis array simultaneously in a time-division multiplexing fashion.

Due to the use of crossbar array structure, for a selective addressing of a single synthesis well, one row and column line can be activated at the same time. By use of the time multiplexing schema as described above, a more time effective molecular synthesis process may be performed on the molecular synthesis device. More specifically, since a time of the voltage pulses can be made much shorter than a time of the reaction (e.g. 1 ms vs 10 s) it is possible to multiplex through all the upper and lower electrode lines associated with the set of selected synthesis cells, which may effectively work as if all of the selected synthesis cells were activated at the same time. To facilitate the multiplexing approach, enough charge needs to be stored in a short period of time to allow the reaction to keep taking place while multiplexing through the other electrode lines, which, as discussed above, may be provided by the self-capacitance of the synthesis wells.

The molecular synthesis device may further comprise a cover arranged on the molecular synthesis array and defining a synthesis compartment over the upper surface of the insulating layer for containing a solution comprising synthesis reagents, wherein the synthesis compartment may communicate with the synthesis wells of the plurality of synthesis cells. Accordingly, the synthesis compartment and the synthesis wells of the molecular synthesis device may during use comprise a solution comprising a synthesis reagent.

The molecular synthesis device may further comprise a set of reagent compartments, each configured to contain a reagent solution; an arrangement of fluidic channels coupled between the set of reagent compartments and the synthesis compartment and configured to forward a reagent solution from each reagent compartment to the synthesis compartment; and a fluidic controller configured to control forwarding of the reagent solutions from the reagent compartments to the synthesis compartment.

According to a third aspect of the present inventive concept, there is provided a data storage system. The data storage system comprises a molecular synthesis device according to the second aspect, and a memory controller configured to receive an input data stream to be stored at selected locations in the synthesis array, and to cause the array controller to enable synthesis in the selected synthesis cells based on the input data stream.

According to a fourth aspect of the present inventive concept, there is provided a method for enabling synthesis in a selected synthesis cell of a molecular synthesis array of a molecular synthesis device according to the second aspect. The method comprises applying a select voltage to the row line coupled to the selected synthesis cell and a synthesis voltage to the column line coupled to the selected synthesis cell.

Effects and features of the second, third and fourth aspects of the present invention are largely analogous to those described above in connection with the first aspect of the inventive concept. Embodiments mentioned in relation to the first aspect of the present invention are largely compatible with the further aspects of the invention. In order to avoid undue repetition, reference is made to the above.

### Brief description of the drawings

The above and other aspects of the present inventive concept will now be described in more detail, with reference to appended drawings showing variants of the present inventive concept. The figures should not be considered limiting the invention to the specific variant; instead, they are used for explaining and understanding the inventive concept.
Figure 1A is a schematic circuit layout of a molecular synthesis array comprising synthesis cells according to one embodiment.
Figure 1B is a schematic circuit layout of a molecular synthesis array comprising synthesis cells according to a further embodiment.
Figure 2A is a cross-sectional side view of a synthesis cell of a molecular synthesis array according to one embodiment.
Figure 2B is a top view of the synthesis cell of Fig. 2A.
Figure 2C is a cross-sectional perspective view of the synthesis cell of Fig. 2A.
Figure 3 is a schematic view of a molecular synthesis device according to an embodiment.
Figure 4 is a schematic view of a data storage system according to an embodiment.
Figure 5A is a graph for illustrating a write scheme of the molecular synthesis device.
Figure 5B is a schematic illustration of a molecular synthesis array.

### Detailed description

The present inventive concept will now be described more fully hereinafter with reference to the accompanying drawings, in which embodiments are shown. The inventive concept may, however, be implemented in many different forms and should not be construed as limited to the variants set forth herein; rather, these variants are provided for thoroughness and completeness, and fully convey the scope of the present inventive concept to the skilled person.

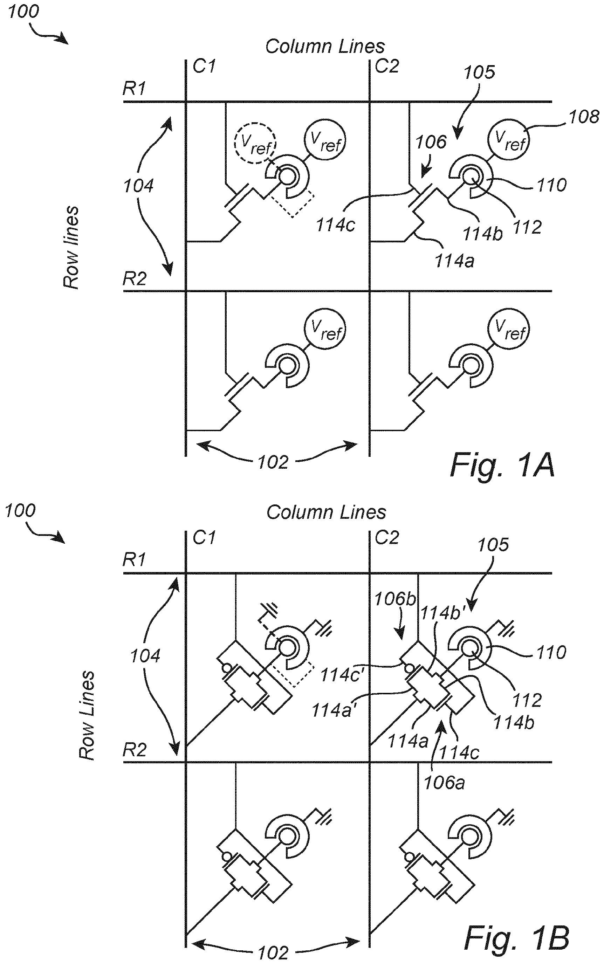

An embodiment of a molecular synthesis array, a molecular synthesis device comprising the molecular synthesis array, a data storage system comprising the molecular synthesis device and method for enabling synthesis in the molecular synthesis device will now be described with reference to Fig. 1 to Fig. 5B. It is to be noted that the relative sizes and shapes of the different layers or components may not be representative to a physical realization of the corresponding device. For example, some structures and layers may have been exaggerated herein for illustrative purposes.

The present inventive concept may be used for any application that makes use of in situ DNA synthesis and that requires high density and hence, ultra-high throughput, such as e.g., DNA data storage, gene expression profiling, spatial transcriptomics, etc. Additionally, it may be used to drive other electrochemical reactions as well, not only for DNA synthesis, but also for synthesis of polymers and RNA.

In a data storage application, stable organic molecules (such as polymers, DNA or RNA) may be synthesized in a structured manner to form molecules mapping to data symbols. Being aware of the data encoding scheme employed during writing, i.e. the mapping between data symbols and the building structures of the synthesized molecules, the written data symbols may accordingly be read-out from the structure of the synthesized molecules, e.g. the sequence of monomers (for polymers) or base pairs (for DNA or RNA). In other words, the molecular synthesis array can be used to control the generation of oligonucleotide chains, which can be user to encode data similar to bits.

According to the present inventive concept there is provided a molecular synthesis array comprising an array of synthesis cells coupled to column and row lines, each synthesis cell comprising a synthesis cell defining a respective synthesis location. Reagents for the synthesis may be supplied to the synthesis locations by means of valves and channels, such as microfluidic channels. Subsequently, a synthesizing chemical reaction may be enabled by biasing the upper and lower electrodes of a selected synthesis cell using the respective pair of column and row lines coupled to the synthesis cell. In the following, reference will mainly be made to solid-phase DNA synthesis controlled through ion generation. It is however envisaged that the molecular synthesis array is compatible also with other synthesis reactions with a reaction rate controllable through an electrochemically induced oxidation-reduction (redox) reaction.

The in situ synthesis of DNA microarrays is based on conventional solid-phase DNA synthesis. In brief, consecutive synthesis cycles are performed to add phosphoramidites nucleotides to the growing surface-tethered oligonucleotide chain. Each synthesis cycle may consist of the following four steps: phosphoramidite nucleotides coupling, capping, phosphite backbone oxidation and deprotection of the coupled nucleosides to allow the addition of the next phosphoramidite nucleotides. The locally controlled deprotection step (detritylation) enables to add nucleotides at desired positions only and allows therefore for the parallel synthesis of multiple DNA strands.

On electrode arrays, such as the molecular synthesis array of the present invention, the detritylation step may be induced electrochemically. In brief, the synthesis location (i.e. the synthesis well) may be flushed with a detritylation solution containing a redox couple (e.g. hydroquinone/benzoquinone, hydrogen/fluoride, hydrogen/chlorine, or any other redox couple in which the reaction is not limited by diffusion (i.e. a redox reaction dominated by Butler-Volmer kinetics)) known to release protons (e.g. in the form of hydrogen ions, H⁺) upon oxidation. An oxidation potential with respect to a working electrode and a counter electrode of the synthesis location can be applied where the next nucleotide addition is required. The oxidation reaction occurring at the surface of the selected electrode leads to the release of protons at the electrode surfaces of the synthesis location which results in a localized pH drop which induces the removal of the phosphoramidite's DMT (dimethoxytrityl) protecting group at the surface-tethered oligonucleotide chain. For example, a reaction rate *v* of the synthesis reaction may be linearly dependent on the powered product of a reactant concentration (e.g. *v = k*[*H*⁺]*^{s}*[*Nucleoside* + *DMT*]*^{t}*, where [*H*⁺] is the proton concentration, and *[Nucleoside* + *DMT]* is the concentration of the nucleoside with the DMT protecting group of the phosphoramidite). In a subsequent step, the next nucleotide can be added to the chain.

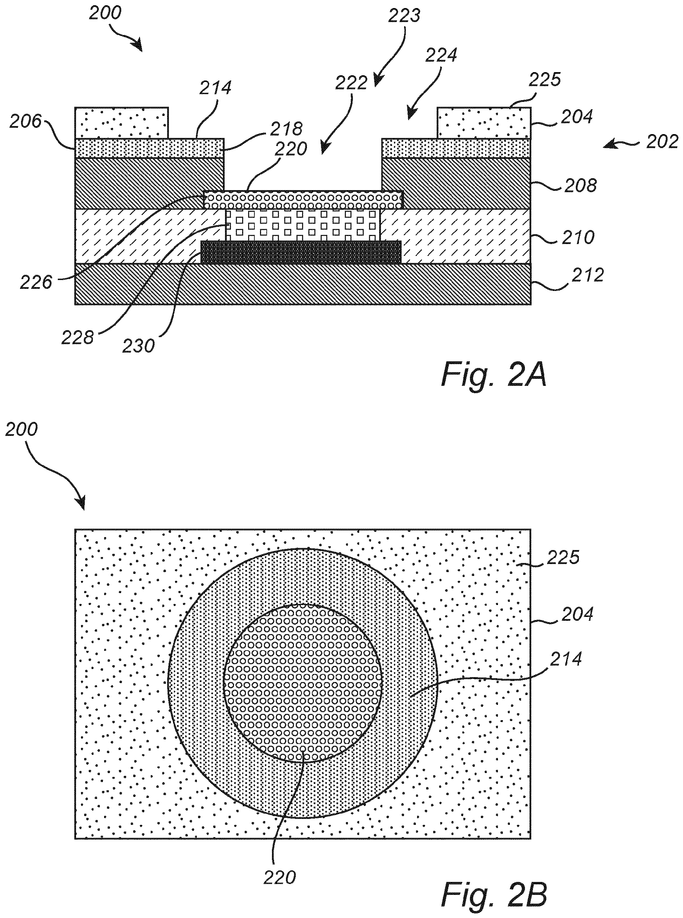

Figure 1A illustrates, by way of example, a circuit layout of the molecular synthesis array 100 according to one embodiment in a schematic view. An example structure of the molecular synthesis array 100 is further described in connection with Fig. 2A to 2C. To clearly illustrate the electrical connections of the molecular synthesis array 100 the placement and size of the components in the circuitry layout may be exaggerated and should not be seen as limiting of an actual molecular synthesis array 100.

The molecular synthesis array 100 comprises a plurality of column lines 102. For illustrative purposes the molecular synthesis array 100 is herein illustrated as having two column lines, C1 and C2. It should however be noted that the molecular synthesis array 100 may comprise any number of column lines. The plurality of column lines 102 extends in parallel along a column direction of the molecular synthesis array 100.

The molecular synthesis array 100 further comprises a plurality of row lines 104. For illustrative purposes, the molecular synthesis array 100 is herein illustrated as having two row lines, R1 and R2. However, the molecular synthesis array 100 may comprise any number of row lines. In the illustrated example, the molecular synthesis array 100 comprises a same number of column and row lines (e.g. to define an array with a square layout). However, the molecular synthesis array 100 may comprise a different number of column and row lines (e.g. to define an array with a non-square rectangular layout). The plurality of row lines 104 extends in parallel along a row direction of the molecular synthesis array 100.

The row direction is transverse to the column direction. In the illustrated example, the row direction is perpendicular to the column direction. However, the row direction and the column direction may extend across each other at an angle other than a right angle, such as at a slightly oblique angle. Further, the row and column lines are vertically separated, both physically and galvanically..

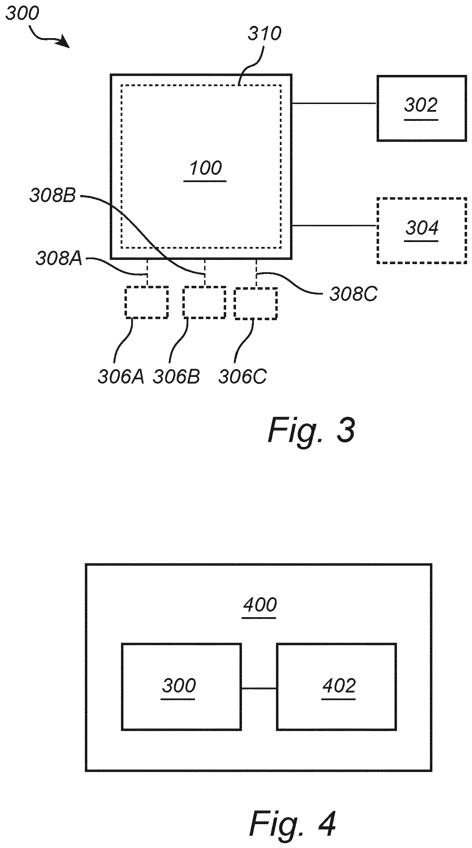

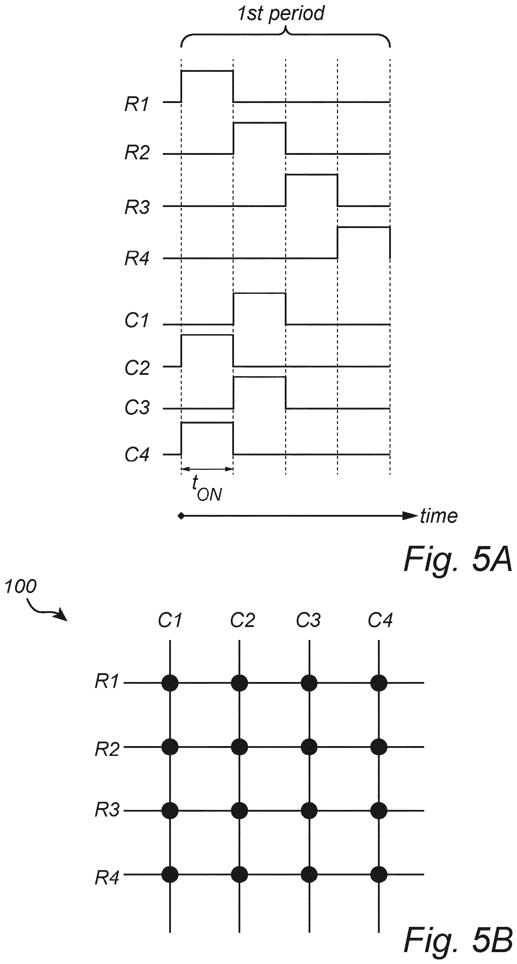

The molecular synthesis array 100 further comprises a plurality of synthesis cells 105. Each synthesis cell may function as a synthesis location of the molecular synthesis array 100. Each synthesis cell is coupled to a respective pair of a column line and a row line. A synthesis cell can be selected by biasing the corresponding row and column line. As an example, synthesis cell C1-R1 may be selected by applying a first voltage (e.g. "synthesis voltage") to the first column line C1 and a second voltage (e.g. "select voltage") to the first row line R1. As will be further described in connection with Fig. 3, the voltages may be supplied by an array controller coupled to the row and column lines. The addressing scheme will be described in greater detail below in connection with Fig. 5A and 5B.

Each synthesis cell comprises a lower electrode 112 and an upper electrode 110. The lower electrode 112 may be configured as a working electrode and the upper electrode 110 may be configured as a counter electrode of the respective synthesis cells. Each synthesis cell further comprises a synthesis well. The synthesis well exposes a surface portion of the upper electrode and a surface portion of the lower electrode of the synthesis cell (further illustrated in Fig. 2A to 2C).

The synthesis wells of the plurality of synthesis cells 105 may be arranged with a regular spacing along the row and column directions. A distance between two neighboring synthesis wells along a column direction or a row direction may be referred to as the pitch of the molecular synthesis array 100. The pitch of the molecular synthesis array 100 may correspond to the pitch of the column and row lines. While Fig. 1A indicates that the pitches along the column direction and the pitch along the row direction may be the same, it is envisaged that the array may present different pitches along the column and row directions.

Each synthesis cell further comprises a single select transistor 106 ("1T cells"). The select transistor 106 is configured as a three-terminal selector device for the synthesis cell. The select transistor 106 has a first terminal 114a, a second terminal 114b and a gate terminal 114c. The first terminal 114a and the second terminal 114b forms a respective source/drain terminal of the select transistor 106. In the illustrated example, the gate terminal 114c is coupled to the row line. Thus, the row line may be used as a select line or word line to switch the select transistor 106 on by applying the select voltage. For example, for an n-type MOSFET the select voltage may be a positive voltage exceeding a threshold voltage of the selector transistor 106 (e.g. a high logic level voltage). The first terminal 114a (i.e. source or drain of the transistor) is coupled to the column line. Thus, the column line may be used as a bit line to supply a synthesis voltage to the synthesis cell. The synthesis cells in Fig. 1A are of the so-called first configuration and accordingly the second terminal 114b of the select transistor 106 is coupled to the lower electrode 112, and the upper electrode 110 is coupled to a reference voltage (V_{ref}).

In the illustrated example, the reference voltage is a reference voltage source 108 switchable between a first and second reference voltage level. The first reference voltage level may be a ground voltage and the second reference voltage level may be a positive reference voltage. This way, both a positive and negative polarity voltage may be applied across the synthesis cell. For example, a positive polarity voltage (as seen from the lower electrode 112 to the upper electrode 110) may be provided by applying a positive voltage to the column line C2 and the first reference voltage level to the upper electrode 110. Meanwhile, a negative polarity voltage (as seen from the lower electrode 112 to the upper electrode 110) may be provided by applying the second reference voltage level to the upper electrode 110 and a ground voltage (or another low level voltage smaller than the second reference voltage level) to the lower electrode 112.

While Fig. 1A illustrates a separate reference voltage source for each synthesis cell 105, the respective upper electrode 110 of the synthesis cells may also be coupled to a common reference voltage. Thereby, a common reference voltage may be applied simultaneously to the respective upper electrodes of the plurality of synthesis cells 105. For example, the upper electrodes may be formed by a common metal layer extending over the synthesis array 100, or by a plurality of metal lines, e.g. extending along the row or column direction.

The synthesis cells 105 may alternatively be arranged according to the so-called second cell configuration, wherein instead the upper electrode 110 is coupled to the second terminal 114b of the select transistor 106 and the lower electrode 112 is coupled to the reference voltage. The second cell configuration is schematically exemplified by the dashed lines in the synthesis cell coupled to row line R1 and column line C1. The above description of the reference voltage with reference to the first cell configuration, applies correspondingly to the second cell configuration, with the difference that the polarity of the voltages are reversed.

Figure 1B illustrates, by way of example, a circuit layout of the molecular synthesis array 100 according to a further embodiment in a schematic view.

The molecular synthesis array 100 has two column lines, C1 and C2, two row lines, R1 and R2, and 4 synthesis cells.

As opposed to the molecular synthesis array 100 of Fig. 1A, each synthesis cell of Fig. 1B comprises two select transistors ("2T cells"). Namely, a first select transistor 106a of a first conductivity type (e.g. n-type) and a second select transistor 106b of an opposite conductivity type (e.g. p-type). Hence, the selector device 106 of each synthesis cell 105 may be a Complementary Metal Oxide Semiconductor (CMOS) pair of transistors.

Each of the first and second select transistors 106a, 106b has a first terminal 114a, 114a', a second terminal 114b, 114b' and a gate terminal 114c, 114c'. The first terminal 114a, 114a' and the second terminal 114b, 114b' forms a respective source/drain terminal of the respective first and second select transistor 106a, 106b. In the illustrated example, the gate terminals 114c, 114c' of the first and second select transistor 106a, 106b is coupled to the row line. The first terminals 114a, 114a' of the first and second select transistor 106a, 106b is coupled to the column line. Thus, similar to the embodiment in Fig. 1A, the row and column lines may be used as select lines / word lines and bit lines, respectively. The second terminals 114b, 114b' of the first and second select transistor 106a, 106b is coupled to the lower electrode 112. The upper electrode 110 is coupled to a reference voltage in the form of a ground voltage. In other words, the potential of the upper electrode 110 is set to ground. More generally, the reference voltage may instead be a low (logic) level voltage or a negative supply voltage (e.g. VSS) supplied by a reference voltage source. By having a first and a second select transistor 106a, 106b of opposite conductivity types, the lower electrode 112 may be supplied with both a positive and a negative voltage, so that a either a positive or negative polarity voltage may be applied across the synthesis cell. The upper electrodes 110 of the plurality of synthesis cells 105 may be coupled to a common ground, to simplify the circuit layout. While Fig. 1B illustrates a separate reference voltage (e.g. ground) for each synthesis cell 105, the respective upper electrode 110 of the synthesis cells may also be coupled to a common reference voltage (e.g. common ground). For example, the upper electrodes may be formed by a common metal layer extending over the synthesis array 100, or by a plurality of metal lines, e.g. extending along the row or column direction, the metal layer or metal lines forming a common ground plane for the plurality of synthesis cells 105.

While the illustrated example corresponds to the so-called first cell configuration, the so-called second configuration may be used also in a 2T cell, wherein the second terminals 114b, 114b' of the first and second select transistor 106a, 106b may be coupled to the upper electrode 110 and the lower electrode 112 may be coupled to the reference voltage (e.g. ground). The second cell configuration is schematically exemplified by the dashed lines in the synthesis cell coupled to row line R1 and column line C1.

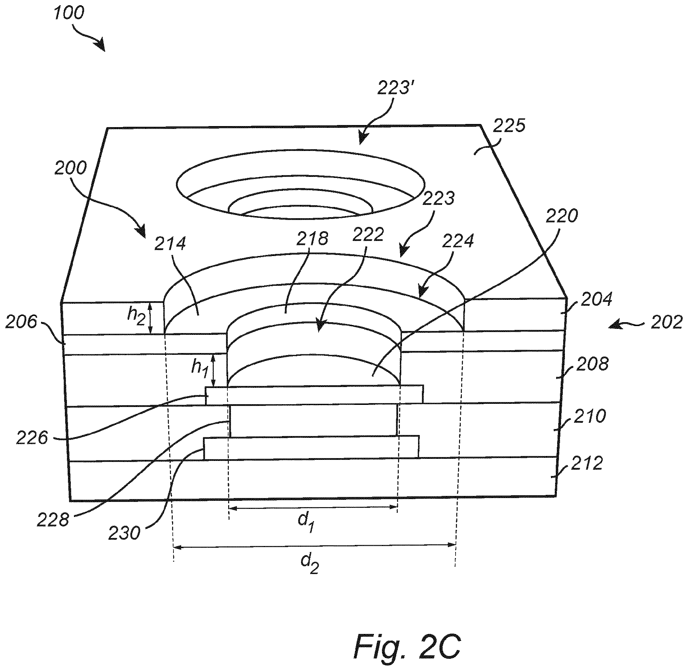

Figure 2A is a cross-sectional side view of a synthesis well 223 of a synthesis cell 200 of a molecular synthesis array 100 according to one embodiment. Figure 2B is a top view of the same synthesis cell 200. Fig. 2C is a perspective cross-sectional view through the same synthesis cell 200 wherein also a further a synthesis well 223' of a neighboring synthesis cell is visible. The synthesis well 223 of the synthesis cell 200 as shown in Figs 2A-C is generally representative for the synthesis well of any one of the plurality of synthesis cells 105 of the array 100 as shown in Figs 1A-B.

As described above, the synthesis cell 200 is coupled to a respective pair of a column line and a row line. The column and row lines are not shown in an individualized manner in Figs. 2A-C but considered to form part of a schematically shown substrate layer 212 comprising e.g. a semiconductor substrate with CMOS devices and interconnect structures formed thereon. The column and row lines may be formed by any material suitable for forming CMOS interconnect structures, e.g. copper, aluminum, tungsten, as a few non-limiting examples.

The synthesis cell 200 comprises an upper electrode 206 and a lower electrode 226. The upper and lower electrodes 206, 226, may be formed by any material suitable as an electrode material. Examples include, but are not limited to, platinum, gold and ruthenium. The lower electrode 226 may be configured as a working electrode and the upper electrode 206 may be configured as a counter electrode of the synthesis well 223.

The lower and upper electrodes 206, 226 of the synthesis cell 200 are embedded in an insulating layer 202. The insulating layer 202 may as indicated be a composite stack. In other words, the insulating layer 202 may comprise a plurality of insulating layers 204, 208, 210 of one or more insulating materials. For example, the insulating layer 202 may comprise one or more layers of silicon oxides and/or silicon nitrides. In particular, the lower and upper electrodes 206, 226 may be entirely encapsulated by the insulating layer 202 (except from exposed surface portions of the upper and lower electrodes 206, 226 in a synthesis well 223, as explained below). The upper and lower electrodes 206, 226 are vertically separated from each other by a distance *h*₁. A portion 208 of the insulating layer 202 is thus arranged between the upper and lower electrodes 206, 226, to separate them from each other. The insulating layer 202 further comprises an upper portion 204 arranged on and covering the upper electrode 206. The upper portion 204 of the insulating layer 202 has a thickness denoted by *h₂*, as seen in Fig. 2C.

The synthesis well 223 extends from an upper surface 225 of the insulating layer 202 to the lower electrode 226, through the insulating layer 202 and through the upper electrode 206. The synthesis well 223 thereby exposes an upper surface portion 214 of the upper electrode 204 and an upper surface portion 220 of the lower electrode 226. The surface portion 220 of the lower electrode 226 forms a bottom-most surface of the synthesis well 223. The exposed surface portions 214, 220 of the upper and lower electrodes 206, 226 may serve as the electrode surfaces for the synthesis well 223 in question.

The synthesis wells may be circular wells, as seen in Fig. 2B. However, as the skilled person realizes, the synthesis wells may have other shapes as well, such as polygonal or elliptical.

The synthesis well 223 may as shown comprise an upper portion 224 and a lower portion 222. The upper portion 224 and the lower portion 222 of the synthesis well 223 may be centered in relation to a common central axis as seen along a vertical direction (e.g. towards the substrate). The upper portion 224 extends from the upper surface 225 of the insulating layer 202 to the upper electrode 206 and exposing the upper surface portion 214 of the upper electrode 206. The lower portion 222 of the synthesis well 223 extends from and through the upper electrode 206 to the lower electrode 226. As is seen in Fig. 2B, the upper electrode surface 214 circumferentially encloses a top-most part of the lower portion 222 of the synthesis well 223 formed through the upper electrode 206, i.e. the hole in the upper electrode 206. As indicated in Fig. 2A-C, the hole / top-most part of the lower portion 222 also exposes a side surface portion 218 of the upper electrode 206 (surrounding the hole in the upper electrode 206).

The lower portion 222 of the synthesis well 223 has a first diameter, as indicated by the label *d*₁. The upper portion 224 of the synthesis well 223 has a second diameter, as indicated by the label *d*₂. As may be seen in Fig. 2A-B, *d*₂ is greater than *d*₁, so that a cross-sectional area of the upper portion 224 (as seen along the vertical direction) exceeds a cross-sectional area of the lower portion 222. In particular, an area of the exposed upper surface portion 214 of the upper electrode 206 may be larger than an area of the exposed surface portion 220 of the lower electrode 226. For example, the area of the exposed upper surface portion 214 of the upper electrode 206 may be at least two times larger than the area of the exposed surface portion 220 of the lower electrode 226, such as about 3 times larger.

In any case, the vertical separation between the lower electrode 226 and the upper electrode 206 may be smaller than a spacing between the synthesis well 200 and the neighboring synthesis well 200' (as seen in Fig. 2C) (i.e. the pitch of the molecular synthesis wells 223), as this improves the selectivity of the addressing scheme. As a non-limiting example of the dimensions related to the synthesis well 223, *h*₁, may be 40 to 300 nm, *h*₂ may be 40 to 300 nm. The pitch *p* of the synthesis wells may for example be at least two times *h*₁.

As an alternative to upper and lower portions 224, 222 of the synthesis well 223 of different diameters, it is contemplated that a width of the synthesis well 223 may be the same along the depth dimension the synthesis well 223. In such case, the side surface portion 218 of the upper electrode 206 enclosing the hole through the upper electrode 206 may be the only exposed electrode surface of the upper electrode 206.

As described above in connection with Fig. 1A, the synthesis cell 200 further comprises a select transistor 106. Alternatively, as described in connection with Fig. 1B, the synthesis cell 200 may comprise a first and a second select transistor 106a ,106b. The select transistor(s) 106/106a-b may like the column and row lines be comprised in the substrate layer 212. The second term inal 114b of the select transistor 116, or the second term inals 114b and 114b' of the select transistors 106a, 106b may be coupled to the lower electrode 226 through an interconnect structure, e.g. comprising a first interconnect part 230 extending from the terminals 114b/114b, 114b' to a second interconnect part in the form of a metal via 228 coupling the lower electrode 226 to the first interconnect part 230. In case the select transistor(s) 106/106a-b are formed within the footprint of the lower electrode 226, the first interconnect part 230 may simply be a metal contact abutting the second terminals 114b/114b,114b' of the select transistor(s). However, the select transistor(s) 106/106a-b may more generally be displaced relative the lower electrode 226, wherein the first interconnect part 230 may comprise a combination of horizontal and vertical routing resources extending to a location underneath the lower electrode 226 and the metal via 228.

As mentioned above in connection with Fig. 1A and 1B, the upper electrodes 206 may be formed by a single metal layer common to all synthesis cells 105. Alternatively, the upper electrodes 206 may be formed by metal lines extending in the row and/or column direction of the synthesis cell 105, thereby connecting the upper electrodes 206 along a row and/or a column together.

Figure 3 is a schematic view of a molecular synthesis device 300. The molecular synthesis device 300 comprising a molecular synthesis array 100 of any one of the embodiments described in connection with Fig. 1A to 2C. The molecular synthesis device 300 further comprises an array controller 302. The array controller 302 enables the synthesis in a selected synthesis cell among the plurality of synthesis cells of the molecular synthesis array 100. The array controller 302 enables the synthesis by applying select voltages, synthesis voltages and optionally reference voltages to the synthesis cells, as described above in connection with Figs. 1A-B. For the purpose of providing voltages and currents to the synthesis cells, the array controller 302 may comprise driver circuitry including column line drivers and row line drivers, and optionally controlled voltage sources for supplying a switchable reference voltage. The function and implementation of such driver circuitry is per se known to the skilled person and will therefore not be further described herein.

The array controller 302 may be further configured to enable synthesis in a set of selected synthesis cells in parallel. The parallel synthesis may be performed by supplying a respective train of voltage pulses to each synthesis cell of the set of selected synthesis cells, wherein the trains of voltage pulses are applied to the molecular synthesis array 100 simultaneously in a time-division multiplexing fashion. An example of how the synthesis can be performed in the time-division multiplexing fashion is further described in connection with Fig. 5A and 5B below.

The molecular synthesis device 300 may further comprise a cover arranged on the molecular synthesis array 100 define a synthesis compartment or fluidic cell 310 over the upper surface of the insulating layer for receiving and containing a solution comprising synthesis reagents (i.e. a reagent solution). The synthesis compartment 310 may communicate with the plurality of synthesis wells. Accordingly, a solution received in the synthesis compartment 410 may flow into and fill the synthesis wells.

The molecular synthesis device 300 may further comprise a set of reagent compartments 306A-C. Each reagent compartment of the set of reagent compartments 306A-C may be configured to contain a reagent solution. The different reagent compartments of the set of reagent compartments 306A-C may contain different reagent solutions, e.g. reagent compartments comprising solutions with different phosphoramidites nucleotides, and a reagent compartment comprising a detritylation solution comprising a redox couple to facilitate proton release in selected synthesis wells and thus enable a synthesis reaction therein.

The molecular synthesis device 300 may further comprise an arrangement of fluidic channels 308A-C coupled between the set of reagent compartments 306A-C and the synthesis compartment 310 and configured to forward a reagent solution from each reagent compartment to the synthesis compartment 310. The fluidic channels may for example be microfluidic channels. Additional fluidic channels may be present for managing the flow of reagent solution within the molecular synthesis device 300.

The molecular synthesis device 300 may further comprise a fluidic controller 304. The fluidic controller 304 may be configured to control forwarding of the reagent solutions from the reagent compartments 306A-C to the synthesis compartment 310. The fluidic controller 304 may e.g. be a microfluidic controller. The fluidic controller 304 may control the flow of the reagent solutions using techniques which per se are known in the art, for instance by controlling valves arranged along the fluidic channels 308A-C.

The molecular synthesis device 300 may be configured to enable synthesis of oligonucleotides tethered to the surface portion of the lower electrodes of the synthesis wells of the synthesis array 100 using solid-phase DNA synthesis, wherein the molecular synthesis device 300 may be configured to enable synthesis in a selected synthesis cell (or a set of selected synthesis cells using time division multiplexing) by applying a voltage across the synthesis well of the selected synthesis cell(s), via the column and row lines coupled to the selected synthesis cell(s), to cause deprotection of a protected nucleoside of an oligonucleotide chain tethered to the surface portion of the lower electrode of the selected synthesis cell(s). A nucleotide in the reagent solution may thereby be added to the oligonucleotide chain. As described above, the applied voltage may induce an oxidation reaction of a redox couple in the reagent solution such that protons may be released at the electrode surface and enable the deprotection (e.g. removal of the protecting group from the oligonucleotide chain). This process may be repeated to sequentially add nucleotides to the oligonucleotide chain. The type of nucleotide added may be varied by changing between reagent solutions comprising the desired type of nucleotide, e.g. adenine, cytosine, thymine or guanine (A, C, T, G).

In addition to inducing deprotection to enable addition of a nucleotide to the oligonucleotide chain through proton generation, which implies a voltage of positive polarity across the lower electrode (working electrode) and the upper electrode (counter electrode) of a selected synthesis well, a negative polarity voltage may be applied to enable a grafting process. Grafting refers to the process of functionalizing the working electrode for the synthesis, i.e. attaching one or more anchoring molecules (such as diazonium compound) to the lower electrode on which a (respective) oligonucleotide chain can be synthesized. Grafting may, like nucleotide-addition, be selectively enabled by applying a voltage of a negative polarity across the lower electrode and the upper electrode of a selected synthesis well. It is however contemplated that grafting alternatively may be enabled non-selectively, i.e. in all synthesis wells of the synthesis array as an initialization step preceding (selective) sequential oligonucleotide in the synthesis wells. As may be appreciated, the magnitudes of the positive polarity voltage (for deprotection) and the negative polarity voltage (for grafting) may be different.

Figure 4 is a schematic view of a data storage system 400. The data storage system 400 comprises a molecular synthesis device 300, e.g. as described above in connection with Fig. 3. The data storage system 400 further comprises a memory controller 402. The memory controller 402 is configured to receive an input data stream to be stored at selected locations in the molecular synthesis array of the molecular synthesis device 300. The memory controller 402 may be configured to cause the fluidic controller 304 to supply the appropriate reagents solution to the synthesis array 100, responsive to the input data stream. The memory controller 402 may further be configured to cause the array controller of the molecular synthesis device 300 to enable synthesis in the selected synthesis cells based on the input data stream. Thus, the data storage system 400 may thus allow for storing data in the molecular synthesis device 300 by molecular synthesis.

The memory controller 402 may be configured to map a received data symbol of the input data stream to a respective nucleotide or a respective sequence of nucleotides. For example, using four nucleotides A, C, T and G data symbols may be stored in a base 4 system. In other words, the memory controller 402 may translate data symbols of the input data stream from a binary format to a "polymer" domain wherein the input data stream is expressed as a sequence of polymers. The memory controller 402 may thereafter synthesize the sequence of polymers in in one or more selected synthesis wells.

Figure 5A is a graph illustrating a scheme for enabling synthesis in one or more selected synthesis cells of the molecular synthesis device, such as the molecular synthesis device 300 as described above in connection with Fig. 3. Figure 5B is an schematic illustration of an example of the molecular synthesis array having four column lines, C1 to C4, four row lines, R1 to R4 and 16 synthesis cells (illustrated as circles) coupled to each pair of column and row line.

In the simplest case, where only a single synthesis cell is to be addressed (i.e. having data written to it), a single activation pulse of sufficient length to complete the reaction can be applied to the corresponding column and row lines. When activating a synthesis cell, the activation pulses (i.e. voltage pulses) are such that either a positive or negative bias is applied across that synthesis well, depending on what reaction is to be performed (e.g. deprotection or grafting). Thus, the polarity of the activation pulses applied to the lower and upper electrodes of the selected synthesis cell may be either a positive or negative potential. Row and/or column lines coupled to non-selected synthesis cells may be left floating (e.g. disconnected from the driving from the driving circuitry of the array controller).

As described above, synthesis reactions may be enabled in a set of synthesis cells in parallel by applying trains of activation/voltage pulses to the synthesis array in a time division multiplexing fashion.

Such an approach will now be described with reference to Fig. 5A and 5B and an example where synthesis is to be enabled in synthesis cells at the crossings between R1-C2, R1-C4, R2-C1 and R2-C3 (as seen in Fig. 5B) simultaneously. Fig. 5A illustrates a first period of a number of trains of pulses. Each train of pulses corresponds to a row and column line. As mentioned above, the pulses represent the activation of the individual row and column lines, rather than an actual potential being applied, since, depending on the cause, either a positive or negative bias may be applied when activating a synthesis cell. The respective "activation pulses" applied to the rows R1-R4 and the columns C1-C4 may hence be referred to as row address strobes and column address strobes, respectively. A length in time of the first period may correspond to a time which the self-capacitance of each synthesis cell is able to hold enough charge to allow the synthesis reaction to continue to be performed, even though no external bias is applied. The first period of train of activation pulses may be repeated until the synthesis reaction in the synthesis wells is finished.

The first period is split into four time segments. Each time segments corresponds to a pulse length of each pulse, denoted by t_{ON}.

In the first time segment, an activation pulse is applied to the first row line R1. In addition, activation pulses are applied to the second and fourth column lines, C2 and C4. Thus, synthesis cells R1-C2 and R1-C4 are activated for a time period of t_{ON}, after which, the first row line R1, as well as the second and fourth column lines, C2 and C4, are deactivated for the rest of the first period.

In the second time segment an activation pulse is applied to the second row line R2. In addition, activation pulses are applied to the first and third column lines, C1 and C3. Thus, synthesis cells R2-C1 and R2-C3 are activated for a time period of t_{ON,}, after which they are deactivated.

In the third and fourth time segments, activation pulses are applied to the third and fourth row lines R3 and R4 respectively. However, since no column line is activated, these trains of pulses do not result in any activated synthesis cell.

As stated above, the period of train pulses illustrated herein may be repeated, such that in a subsequent time segment, the synthesis wells R1-C2 and R1-C4 are again activated, and so on.

By this example, it has been illustrated how multiple synthesis cells can be activated simultaneously, by applying trains of activation pulses. By reducing the pulse length, t_{ON}, more synthesis cells may be simultaneously enabled.

Additionally, variations to the disclosed variants can be understood and effected by the skilled person in practicing the claimed invention, from a study of the drawings, the disclosure, and the appended claims.

## Claims

1. A molecular synthesis array (100) comprising:
a substrate;
an insulating layer (202) arranged on the substrate;
a plurality of column lines (102) extending in parallel along a column direction of the molecular synthesis array (100), and a plurality of row lines (104) extending in parallel along a row direction of the molecular synthesis array (100), wherein the column lines (102) are vertically separated from the row lines (104) and extend transverse to the row lines (104),;
a plurality of synthesis cells (105), wherein each cell (200) is coupled to a respective pair of a column line and a row line and comprises:
a lower electrode (226) and an upper electrode (206) vertically separated from each other and embedded in the insulating layer (202),
a synthesis well (223) extending from an upper surface (225) of the insulating layer (202) to the lower electrode (226), through the insulating layer (202) and through the upper electrode (206), wherein the well (223) exposes a surface portion (214) of the upper electrode (206) and a surface portion (220) of the lower electrode (226), and
a select transistor (106) having a first terminal (114a), a second terminal (114b) and a gate terminal (114c), the first and second terminals (114a, 114b) forming respective source/drain terminals of the select transistor (106),
wherein the gate terminal (114c) is coupled to the row line, the first terminal (114a) is coupled to the column line, the second terminal (114b) is coupled to the lower electrode (226), and the upper electrode (206) is coupled to a reference voltage, or
wherein the gate terminal (114c) is coupled to the row line, the first terminal (114a) is coupled to the column line, the second terminal (114b) is coupled to the upper electrode (206), and the lower electrode (226) is coupled to a reference voltage.

2. The molecular synthesis array (100) according to claim 1, wherein the well (226) of each synthesis cell (200) comprises an upper portion (224) extending from the upper surface (225) of the insulating layer (202) to the upper electrode (206) and exposing an upper surface portion (214) of the upper electrode (206), and a lower portion (222) extending from the upper electrode (206) to the lower electrode (226).

3. The molecular synthesis array (100) according to claim 2, wherein a cross-sectional area of the upper portion (224) of each well (223) is larger than a cross-sectional area of the lower portion (222) of the well (223).

4. The molecular synthesis array (100) according to claim 2 or 3, wherein an area of the exposed upper surface portion (214) of the upper electrode (206) is at least two times larger than an area of the exposed surface portion (220) of the lower electrode (226).

5. The molecular synthesis array (100) according to any of the claim 1 to 4, wherein the select transistor (106) of each synthesis cell (200) is a first select transistor (106a) of a first conductivity type and each synthesis cell (200) further comprises a second select transistor (106b) of an opposite second conductivity type and having a first terminal (114a'), a second terminal (114b') and a gate terminal (114c'), the first and second terminals (114a', 114b') forming respective source/drain terminals of the second select transistor (106b),
wherein the gate terminals (114c, 114c') of each of the select transistors (106a, 106b) are coupled to the row line, the first terminals (114a, 114a') are coupled to the column line and the second terminals (114b, 114b') are coupled to the lower electrode (226), or
wherein the gate terminals (114c, 114c') of each of the select transistors (106a, 106b) are coupled to the row line, the first terminals (114a, 114a') are coupled to the column line and the second terminals (114b, 114b') are coupled to the upper electrode (206).

6. The molecular synthesis array (100) according to any one of the preceding claims, wherein each lower electrode (226) is configured as a working electrode and each upper electrode (206) is configured as a counter electrode.

7. The molecular synthesis array (100) according to any one of the preceding claims, wherein a vertical separation between the lower electrode (226) and the upper electrode (206) of each synthesis cell (200) is smaller than a spacing of the synthesis wells (223).

8. The molecular synthesis array (100) according to any one of the preceding claims, wherein a vertical separation between the lower electrode (226) and the upper electrode (206) of each synthesis cell (200) is 40 to 300 nm, and a spacing of the synthesis wells (223) is at least 40 nm.

9. A molecular synthesis device (300) comprising a molecular synthesis array (100) according to any one of the preceding claims, and further comprising an array controller (302) configured to enable synthesis in a selected synthesis cell among the plurality of synthesis cells of the molecular synthesis array (100) by:
applying a select voltage to the row line coupled to the selected synthesis cell and a synthesis voltage to the column line coupled to the selected synthesis cell.

10. A molecular synthesis device (300) according to claim 9, wherein the array controller (302) is further configured to enable synthesis in a set of selected synthesis cells in parallel by applying a respective train of select voltage pulses to the row lines coupled to each respective synthesis cell of the set of selected synthesis cells, and a respective train of synthesis voltage pulses to the column lines coupled to each respective synthesis cell of the set of selected synthesis cells, wherein the trains of select voltage pulses and the trains of synthesis voltage pulses are applied to the molecular synthesis array (100) simultaneously in a time-division multiplexing fashion.

11. A molecular synthesis device (300) according to claim 9 or 10, further comprising a cover arranged on the molecular synthesis array (100) and defining a synthesis compartment (310) over the upper surface of the insulating layer for containing a solution comprising synthesis reagents, wherein the synthesis compartment (310) communicates with the synthesis wells of the plurality of synthesis cells.

12. A molecular synthesis device (300) according to claim 11, further comprising:
a set of reagent compartments (306A-C), each configured to contain a reagent solution;
an arrangement of fluidic channels (308A-C) coupled between the set of reagent compartments (306A-C) and the synthesis compartment (310) and configured to forward a reagent solution from each reagent compartment (306A-C) to the synthesis compartment (310); and
a fluidic controller (304) configured to control forwarding of the reagent solutions from the reagent compartments (306A-C) to the synthesis compartment (310).

13. A data storage system (400) comprising a molecular synthesis device (300) according to any of the claims 9 to 12, and a memory controller (402) configured to receive an input data stream to be stored at selected locations in the synthesis array, and to cause the array controller (302) to enable synthesis in the selected synthesis cells based on the input data stream.

14. A method for enabling synthesis in a selected synthesis cell of a molecular synthesis array of a molecular synthesis device (300) according to any of the claims 9 to 13, the method comprising:
applying a select voltage to the row line coupled to the selected synthesis cell and a synthesis voltage to the column line coupled to the selected synthesis cell.
